(19) Europäisches Patentamt
European Patent Office
Office européen des brevets

(11) **EP 1 111 771 A2**

(12) **EUROPEAN PATENT APPLICATION**

(43) Date of publication:
**27.06.2001  Bulletin 2001/26**

(51) Int Cl.⁷: $H03B\ 25/00$

(21) Application number: **00310052.6**

(22) Date of filing: **13.11.2000**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **16.11.1999  JP 32526899**

(71) Applicant: **TDK Corporation**
**Chuo-ku, Tokyo (JP)**

(72) Inventors:
• **Mahon, John-Carl**
  **East Yorkshire, HU13 9HE (GB)**

• **Nagai, Kenta**
  **Chuo-ku, Tokyo (JP)**
• **Katsumata,Masashi**
  **Chuo-ku, Tokyo (JP)**

(74) Representative: **Billington, Lawrence Emlyn et al**
**Haseltine Lake & Co.**
**Imperial House**
**15-19 Kingsway**
**London WC2B 6UD (GB)**

(54) **A multi-band type voltage controlled oscillator**

(57)     A multi-band type voltage controlled oscillator has a resonant circuit part (100) and an oscillating circuit part (200). The resonant circuit part (100) has plural resonant circuits (110, 120) having their resonant frequencies, and controls the plural resonant frequencies in their respective frequency-bands by a frequency control voltage to be applied to a first controlling terminal (103).

The oscillating circuit part (200) has a transistor (T1) of which the base is connected to an output terminal (101) to which the plural resonant circuits (110, 120) are coupled. By changing the capacitance between the emitter and collector of the transistor (T1) with a frequency band selective voltage to be applied to a second controlling terminal (201), an optimum oscillating condition is satisfied at each of the plural resonant frequencies.

*FIG. 1*

EP 1 111 771 A2

**Description**

This invention relates to a voltage controlled oscillator comprising a resonant circuit synchronized with an oscillating frequency to be generated, and an oscillating circuit to oscillate at a resonant frequency, particularly to a multi-band type voltage controlled oscillator to oscillate at plural different frequencies.

A mobile wireless communication terminal unit which can be used at plural frequencies, for example two different frequencies, is proposed and is practically used in some nations. For example, in a dual band system type cellular phone terminal unit, communication is established at two different frequency bands around 800 MHz and 1.8 GHz. Therefore, it is required that the cellular phone terminal unit have two oscillators to oscillate signals with largely different frequencies.

Conventionally, for generating two largely different frequencies, two oscillators, each oscillating one respective frequency, are generally employed. However, since in the dual band system cellular phone terminal unit, two oscillators are required in the transmitting part and the receiving part thereof, respectively, four oscillators are needed for the terminal unit in totality. On the other hand, the cellular phone terminal unit is developed to be miniaturized, saving weight and electric power, and to be low in cost. Therefore, if two oscillators are employed for generating the two different frequencies, these advantages are lost.
Accordingly, it is required that the two different frequenciesbegenerated by one oscillator.

In view of this, an oscillator to generate two signals with respective different frequencies is proposed. In the case of a small interval between the two frequencies, such an oscillator as is disclosed in Japanese Non-examined Patent Publications No. 60-190005, No. 3-96106, and No. 7-202638 may be used. For example, in the oscillator described in the No. 7-202638, two coils provided in a resonant circuit of the oscillator are selectively connected to a circuit by a switch, and thereby, signal is selectively transmitted at a transmitting frequency-band of 160-161 MHz or a receiving frequency-band of 130-131 MHz.

However, the above oscillators can not oscillate selectively at two largely different frequency-bands, for example, around 800 MHz and 1.8 GHz. Such an oscillator as disclosed in Japanese Non-examined Patent Publications No. 8-316731 and No. 10-270937 can oscillate at two largely different frequencies.

In the multi-band type voltage controlled oscillator described in the No. 8-316731, a dielectric resonator with center tap is provided in a resonant circuit connected to a base of an oscillating transistor which operates as an active element of a transmitting circuit in the voltage controlled oscillator, and the center tap is grounded via a switching transistor to vary the oscillating frequency by changing the resonant frequency of the resonant circuit.

However, in the conventional multi-band type voltage controlled oscillator, since the capacitance connected between the emitter and the collector of the oscillating transistor is not changed at all, the oscillating conditions at two different oscillating frequencies are not optimized. Therefore, there is a serious matter in the conventional voltage controlled oscillator that stable oscillation can not be performed at both of the two frequency-bands.

Moreover, employing the dielectric resonator, the voltage controlled oscillator tends to have a complicated structure and a large size, and thus has difficulty in manufacturing and high cost if it is manufactured as a single chip device.

Furthermore, in the multi-band type voltage controlled oscillator described in the No. 10-270937, the oscillating frequency is varied by changing the capacitance between the emitter and the collector of a transistor of an oscillating circuit which operates as an active element, by on/off switching a diode connected to the emitter. However, in this conventional multi-band type voltage controlled oscillator, since the frequency-band of the resonant frequency of a resonant circuit connected to the base of an oscillating transistor can not be switched, the oscillating conditions at both of two different frequency bands are not optimized, and thus, the oscillation becomes unstable in this conventional oscillator. Moreover, although the frequency control voltage thereof is varied by a variable capacitance diode connected to the resonant circuit, and the resonant frequency is fine adjusted in each frequency-band, the oscillating frequency variation for the frequency control voltage variation can not be independently set at the two frequency-bands. Therefore, it becomes difficult to finely adjust the oscillating frequency at the two frequency-bands, and thus it becomes impossible to set the precise oscillating frequency.

Moreover, in this multi-band type voltage controlled oscillator, the oscillating frequency is switched by changing a biasing voltage for the variable capacitance diode provided on the resonant circuit. However, the variable capacitance diode finely adjusts the oscillating frequency in each frequency-band, and thus can not change it largely even if the capacitance of the variable capacitance diode is varied.

According to the present invention there is provided a multi-band type voltage controlled oscillator comprising:

a resonant circuit part having plural resonant frequencies to be controlled in their respective frequency-bands in accordance with a frequency control voltage, and
an oscillating circuit part which is connected to the resonant circuit part and oscillates at an oscillating frequency in a frequency-band selected from the plural frequency-bands in accordance with a frequency band switching voltage.

A preferred embodiment of the present invention may remove or reduce the problems associated with the prior art, and can provide a voltage controlled oscillator which can optimize the oscillating condition thereof at each of plural largely different oscillating frequency-bands and oscillate stably.

The preferred embodiment may also provide a voltage controlled oscillator which can set the controlling voltage and the oscillating frequency thereof independently at each of largely different oscillating frequency-bands, and which can be easily miniaturized and reduced in manufacturing cost.

The resonant circuit may have a resonant circuit and an output terminal connected to the resonant circuit. The oscillating circuit part may have an active element connected to the output terminal.

A voltage controlled oscillator embodying the present invention may have the following three fundamental constructions:

In a first fundamental construction, plural resonant circuits, each having a resonant frequency to be controlled in the respective frequency-band in accordance with the respective frequency control voltage in the above resonant circuit part, are used.

In a second fundamental construction, one resonant circuit, having plural resonant frequencies belonging to their respective frequency-bands which are switched by a resonant frequency-switching voltage and controlled in accordance with a frequency control voltage in the respective frequency-band, is used.

In a third fundamental construction which is a combination of the above first and second fundamental constructions, there is used at least one resonant circuit having a resonant frequency to be controlled in a frequency-band in accordance with a frequency control voltage, and at least one resonant circuit having plural resonant frequencies belonging to their respective frequency-bands different resonant from the frequency-band of the above resonant circuit and controlled in accordance with a frequency control voltage in the respective frequency-band.

In each of the first through the third fundamental constructions, at least one frequency band selective circuit may be provided, which comprises, as an active element of the above-mentioned oscillating circuit part, a transistor of which the base is connected to the output terminal of the above-mentioned resonant circuit part, constitutes the oscillating circuit part as a Colpitts type oscillator to oscillate at a frequency determined by the capacitance between the base and emitter of the transistor, the inductance between the base and collector of the transistor and the capacitance between the emitter and collector of the transistor, and satisfies an optimum oscillating condition at each of the above-mentioned plural frequency-bands by changing the capacitance between the emitter and collector with a frequency band selective voltage.

In a preferred embodiment of the voltage controlled oscillator of the present invention, the frequency band selective circuit, which changes the capacitance between the emitter and collector of the transistor of the oscillating circuit part by the frequency band selective voltage, may have a series circuit composed of a condenser and a diode which are connected to the emitter of the transistor, and a biasing circuit to control the conduction/non-conduction of the diode by applying to it the frequency band selective voltage. The biasing circuit may have an inductor connected between a controlling terminal to which the frequency band selective voltage is applied and the anode of the diode, and a condenser connected between the controlling terminal and a common electric potential point.

Moreover, in a voltage controlled oscillator of the present invention, a frequency control circuit to control each of the plural resonant frequencies of the resonant circuit part by a common frequency control voltage may be provided. In a preferred embodiment of the voltage controlled oscillator of the present invention, the frequency control circuit is composed of a controlling terminal to receive the common frequency control voltage, a variable capacitance diode connected to a resonant circuit and a biasing circuit to change the capacitance of the variable diode by applying the frequency control voltage to it.

In the resonant circuit to switch the plural resonant frequency by the resonant frequency selective voltage in the above third fundamental construction of the voltage controlled oscillator of the present invention, a frequency control circuit to control each of the plural resonant frequencies to be switched by the control voltage may be provided. The frequency control circuit is preferably composed of a controlling terminal to receive the frequency control voltage, a variable capacitance diode, and a biasing circuit to change the capacitance of the variable capacitance diode by applying to it the frequency control voltage.

For a better understanding of this invention, reference is made to the attached drawings, wherein:

Fig. 1 is a circuit diagram of a first embodiment of the first fundamental constructive voltage controlled oscillator of the present invention,

Figs. 2A and 2B are graphs showing the impedance characteristics in a resonant circuit part and an oscillating circuit part in the first embodiment,

Fig. 3 is a circuit diagram of a second embodiment of the second fundamental constructive voltage controlled oscillator of the present invention,

Fig. 4 is a circuit diagram of a third embodiment of the third fundamental constructive voltage controlled oscillator of the present invention,

Fig. 5 is a circuit diagram of a fourth embodiment of voltage controlled oscillator of the present invention,

Fig. 6 is a circuit diagram of a fifth embodiment of voltage controlled oscillator of the present invention, and

Fig. 7 is a circuit diagram showing another embodiment of the oscillating circuit part of a voltage controlled oscillator of the present invention.

Detailed Description of Preferred Embodiments (First Embodiment)

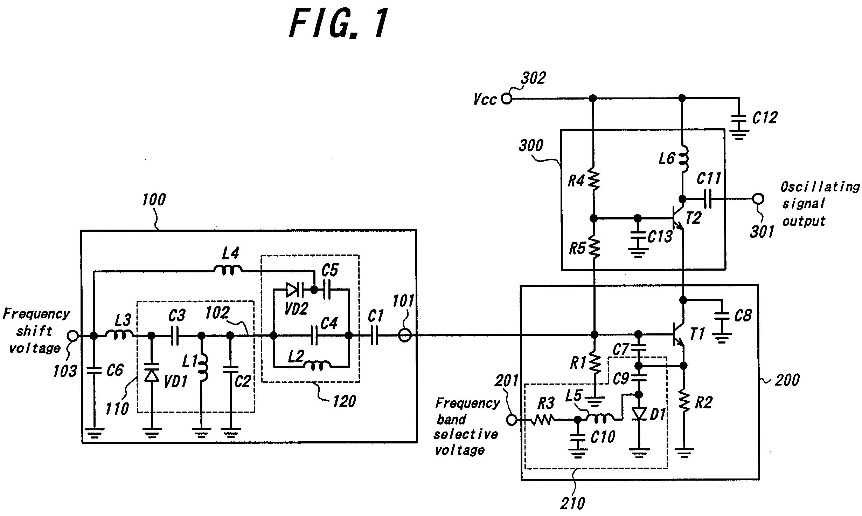

Fig. 1 is acircuit diagram showing a first embodiment of voltage controlled oscillator of the present invention. This embodiment relates to a dual band-type voltage controlled oscillator based on the first fundamental construction as mentioned above. A voltage controlled oscillator in this embodiment includes a resonant circuit part 100, an oscillation circuit 200 part and a buffer part 300. The buffer part 300 is not substantial in the present case. Moreover, in the case of fabricating a chip device from the voltage controlled oscillator in this embodiment by using a substrate including parts of a condenser and a inductor, mounting a transistor, a variable capacitance diode and a resistance on the substrate and connecting a given circuit, the output terminal 101 corresponds to the connected point between the resonant circuit part 100 and the oscillating circuit part 200. Since the connected point is generally composed of a conductive pattern, the output terminal 101 does not always shows such a terminal structure.

In this embodiment, the resonant circuit part 100 has first and second resonant circuits 110 and 120 which are commonly connected to the output terminal 101 of the resonant circuit part 100. In this embodiment, the first resonant circuit 110 is for use in low frequency-band having a central frequency of about 940 MHz, and the second resonant circuit 120 is for use in high frequency-band having a central frequency of about 1.81 GHz. Therefore, the voltage controlled oscillator can be advantageously employed for an oscillator of a dual band-type cellular phone terminal unit in which communication is performed between the above two frequency bands.

The first resonant circuit 110 for low frequency-band and the second resonant circuit 120 for high frequency-band are coupled to the output terminal 101 via a coupling condenser C1. The first resonant circuit 110 has a condenser C2 connected in parallel between a common line 102 connected to the output terminal 101 and a ground, a coil L1, a variable capacitance diode VD1 and a condenser C3 connected between the coil L1 and the variable capacitance diode VD1.

Moreover, the second resonant circuit 120 for high frequency-band has a condenser C4 connected in series to the coupling condenser C1, a coil L2 connected in parallel to the condenser 4 and a series circuit composed of a condenser C5 and a variable capacitance diode VD2. A first controlling terminal 103 to which a frequency control voltage to fine adjust the frequency in each frequency-band is applied, is connected to the variable capacitance diodes VD1 and VD2 in the first and second resonant circuits 110 and 120 via the respective biasing circuit.

That is, the first controlling terminal 103 is connected to the cathode of the variable capacitance diode VD1 via the coil L3, and connected to the cathode of the variable capacitance diode VD2 via the coil L4. Moreover, the controlling terminal 103 is grounded via a condenser C6 to bypass AC signal. By changing the frequency control voltage to be applied to the controlling terminal 103, the resonant frequencies of the first and the second resonant circuits can be fine adjusted. As well known, the frequency control voltage is generated in a PLL (phase lock loop) of an oscillating circuit including the voltage controlled oscillator.

The oscillating circuit part 200 has a transistor T1 as an active element, of which the base is connected to the output terminal 101 of the resonant circuit part 100 and is grounded via a resistance R1. The emitter of the transistor T1 is grounded via a resistance R2, and is connected to the base via a condenser C7. Moreover, the collector of the transistor T1 is grounded via a bypass condenser C8.

In this embodiment, the emitter of the transistor T1 is grounded via a condenser C9 and a diode D1, and the connected point between the condenser C9 and the diode D1 is connected to the second controlling terminal 201 to which a frequency band selective voltage is applied via a coil L5 and a resistance R3. Then, the connected point between the coil L5 and the resistance R3 is grounded via a condenser C10. Since the capacitance between the emitter and base of the transistor T1 is varied by on/off-switching the diode D1 with the frequency band selective voltage to be applied to the second controlling terminal 201. Therefore, the condensers C9 and C10, the coil L5, the resistance R3 and the diode D1 constitutes an oscillating frequency-band selective circuit 210.

The buffer part 300 amplifies an oscillating signal generated on the above oscillating circuit part 200, and outputs the amplified signal to an output terminal 301 of the voltage controlled oscillator. The buffer part 300 has a transistor T2 who's emitter is connected to the collector of the transistor T1 of the oscillating circuit part 200. The collector of the transistor T2 is connected to the output terminal 301 via a condenser C11, and is connected via a coil L6 to an electric current source terminal 302 to which an electric current source Vcc is applied. The electric current terminal 302 is also grounded via a condenser C12. The base of the transistor T2 is grounded via a condenser C13, and is connected to the common connected point between bias divided resistances R4 and R5 which are connected between the electric current source terminal 302 and the output terminal 101 of the oscillating circuit part 100.

Next, the operation of the voltage controlled oscillator will be described. The frequency-band selective voltage to be applied to a second controlling input terminal 201 connected to the oscillating frequency-band selective circuit 210 of the oscillating circuit part 200 takes a not positive first controlling voltage to make non- conducting the diode D1 in the oscillating frequency-band selective circuit, or a positive second controlling voltage to make conducting the diode D1 therein.

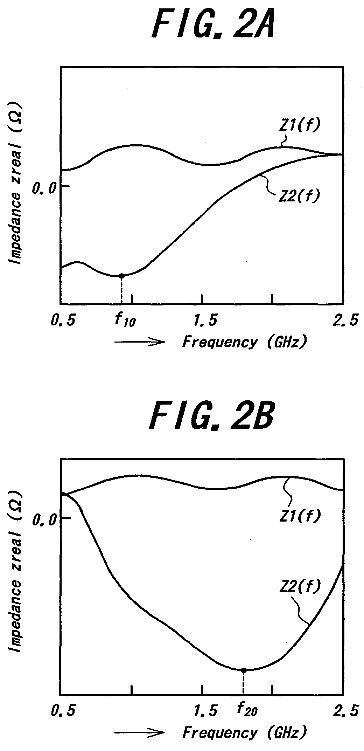

When the frequency-band selective voltage having the first controlling voltage is applied to the second controlling terminal 201, the diode D1 is not in conduction. Therefore, the capacitance generated by the pn junction of the diode is connected between the other end of the condenser C9 of which one end is connected to the emitter of the transistor T1 and the ground, and the impedance between the emitter and collector of the transistor is mainly determined by the capacitance of the condenser C9, the capacitance of the diode D1 at non-conduction and the inductance of the coil L5. In this case, since the oscillating circuit part 200 shows the characteristic as depicted in Fig. 2A, the diode oscillates in lower frequency. Herein, the wording "Z1 (f)" designates the impedance of the resonant circuit part 100 from the output terminal 101 of the resonant circuit part 100, and the wording "Z2 (f)" designates the impedance of the resonant circuit part 200 from the output 101.

When the frequency band selective voltage having the second controlling voltage is applied to the second controlling terminal 201, the diode D1 is rendered in conduction. Then, the other end of the condenser C9 of which the one end is connected to the emitter of the transistor T1 is grounded, and the impedance between the emitter and collector of the transistor T1 is mainly determined by the capacitance of condenser C9. In this case, the oscillating circuit part 200 shows a characteristic as depicted in Fig. 2B and oscillates in higher frequency.

In the oscillating condition, the oscillation starting condition is represented by the equation:

$$Z1(f)+Z2(f)<0 \tag{1}$$

, and the steady state-oscillating condition is represented by the equation:

$$Z1(f)+Z2(f)=0 \tag{2}$$

, wherein the impedances of the resonant circuit part 100 and the oscillating circuit part 200 from the output terminal 101 of the resonant circuit part 100 are designated by "Z1(f)" and "Z2(f)", respectively, as mentioned above. As shown in Figs. 2A and 2B, since the oscillation is started at the largest negative value of the impedance Z2 in the oscillating circuit part 200 from the output terminal 101, that is, at the largest gain of a negative feedback amplifier, the oscillation is performed at the external value of the impedance Z2. The frequencies at the oscillation start are designated by $f_{10}$ and $f_{20}$, respectively. Thereafter, the oscillation frequencies are changed, and the oscillation becomes a steady state at Z1(f)+Z2(f)=0. The oscillating frequencies at the steady state are designated by $f_1$ and $f_2$, respectively.

As mentioned above, when the equation of:

$$Z1(f_1)+Z2(f_1)=0 \tag{3}$$

is satisfied, the voltage controlled oscillator oscillates in steady state at the frequency $f_1$, and the oscillation signal having the frequency $f_1$ is output from the output terminal 301 of the voltage controlled oscillator. Moreover, when the equation of:

$$Z1(f_2)+Z2(f_2)=0 \tag{4}$$

is satisfied, the voltage controlled oscillator oscillates in steady state at the frequency $f_2$, and the oscillation signal having the frequency $f_2$ is output from the output terminal 301 of the voltage controlled oscillator.

Therefore, by defining a circuit constant so that, at the frequency $f_1$ in the lower frequency-band, the impedance $Z1(f_1)$ of the resonant circuit part 100 and the impedance $Z2(f_1)$ of the oscillating circuit part 200 at the non-conduction of the diode D1 by the frequency band selective voltage having the first controlling voltage to be applied to the second controlling terminal 201 connected to the oscillating frequency-band selective circuit 210 of the oscillating circuit part 200

can satisfy the above equation (3), and so that, at the frequency $f_2$ in the higher frequency-band, the impedance Z1 $(f_2)$ of the resonant circuit part 100 and the impedance Z2$(f_2)$ of the oscillating circuit part 200 at the conduction of the diode D1 by the frequency band selective voltage having the second controlling voltage can satisfy the above equation (4), the steady state-oscillation condition can be satisfied in the frequencies $f_1$ and $f_2$, respectively, and a stable oscillation can be performed at the respective frequency.

Moreover, by changing the frequency control voltage to be applied to the first controlling terminal 103 at the oscillation of the first oscillation frequency $f_1$, the oscillating frequency can be adjusted within the first frequency-band around the steady oscillating frequency $f_1$. Similarly, by changing the frequency control voltage to be applied to the first controlling terminal 103 at the oscillation of the second oscillating frequency $f_2$, the oscillating frequency can be adjusted within the second frequency-band around the steady oscillation frequency $f_2$. In this case, since the first and the second resonant circuits 110 and 120 are provided in the resonant circuit part 100 corresponding to the respective frequency-band, the resonant frequency variation for the change of the frequency control voltage is almost the same in both of the first and second frequency-bands.

In other words, according to the present embodiment, the first and second resonant circuits 110 and 120 can have almost the same sensitivity thereof for the frequency control voltage, so that the voltage controlled oscillator of the present embodiment does not have an extraordinary high sensitivity in either oscillating frequency-band, different from the conventional dual band voltage controlled oscillator. Thereby, in the voltage controlled oscillator of the present embodiment, the two oscillating frequencies can be fine adjusted simply and precisely.

(Second Embodiment)

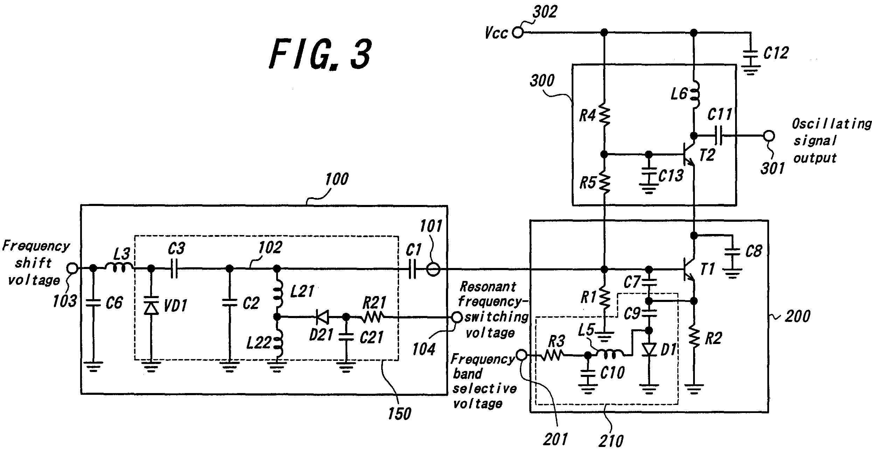

Fig. 3 shows a second embodiment of voltage controlled oscillator of the present invention. This embodiment relates to a dual band-type voltage controlled oscillator based on the second construction as mentioned above. Like references are given to similar parts to the ones in the first embodiment shown in Fig. 1. The oscillating circuit part 200 and the buffer part 300 have similar constructions to the ones shown in the first embodiment of Fig. 1, so will not be explained below.

The construction of the resonant circuit part 100 in this embodiment is different from the one as depicted in Fig. 1. In a resonant circuit 150 provided in the resonant circuit part 100, two frequency-bands are switched by a resonant frequency-switching voltage, and in each frequency band, the resonant frequency is controlled in accordance with the frequency control voltage.

The resonant circuit 150 provided in the resonant circuit part 100 is coupled to an output terminal 101 via a coupling condenser C1. The resonant circuit 150 has a condenser C2 connected between a line 102 coupled to the output terminal 101 and a ground, a variable capacitance diode VD1, a series circuit composed of coils L21 and L22, a condenser C3 connected between the condenser C2 and the cathode of the variable capacitance diode VD1, and a diode D21 of which the cathode is connected to the connected point between the connected in series coils L21 and L22 and of which the anode is connected to a third controlling terminal 104 to which the resonant frequency-switching voltage is applied via a resistance R21 and is grounded via a condenser C21. As mentioned in the above embodiment, a first controlling terminal 103 to which a frequency control voltage is applied is connected to the cathode of the variable capacitance diode VD1 via a coil L3, and is grounded via a condenser C6.

Next, the operation of the voltage controlled oscillator in this embodiment will be explained. When the resonant frequency-switching voltage has a not positive value for making the diode D21 non-conducting, the connected point between the coils L21 and L22 is grounded via the series circuit composed of the capacitance of the diode D21 at the non-conduction and the condenser C21. At the same time, the diode D1 in the oscillating circuit part 200 is made non-conducting. Then, when the impedance Z1(f) of the resonant circuit part 100 and the impedance Z2(f) of the oscillating circuit part 200 satisfy the above equation (1), the voltage controlled oscillator starts to oscillate. Thereafter, the oscillator keeps the steady and stable oscillation at the frequency $f_2$ in the higher frequency band to satisfy the steady oscillating condition of the above-mentioned equation (4).

In this embodiment as well as the above one, a circuit constant can be determined so as to satisfy an optimum oscillating condition in each of the oscillating frequencies $f_1$ and $f_2$, so that the voltage controlled oscillator oscillates stably in each frequency. Moreover, since the change of the oscillating frequency in each of the above frequency-bands in accordance with the variation of the frequency control voltage to be applied to the first controlling terminal 103 can be stabilized, the oscillating frequency can be adjusted easily and precisely in each frequency-band. However, in this embodiment, since the oscillating frequency is changed by on/off-switching the diode D21 provided in the oscillating circuit part 100, the interval between the above two frequency-bands is narrowed in comparison with the one in the above first embodiment, but is broader than the one in the conventional voltage controlled oscillator.

(Third Embodiment)

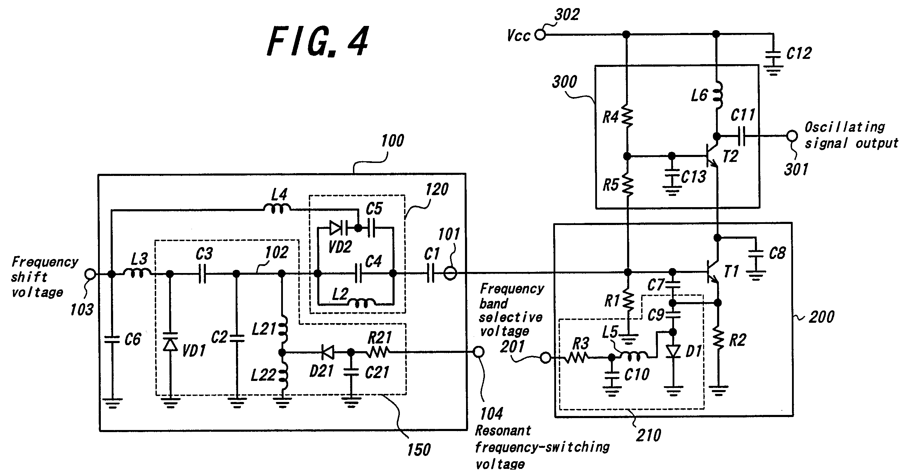

Fig. 4 shows a third embodiment of voltage controlled oscillator of the present invention. This embodiment relates to a triple band-type voltage controlled oscillator based on the above third fundamental construction. Like references are given to the similar parts to the ones in the first and second embodiments shown in Figs. 1 and 3. The oscillating circuit part 200 and the buffer part 300 have similar constructions to the ones shown in the first embodiment of Fig. 1, so will not be explained below.

A resonant circuit part 100 of this embodiment has a combined construction of the ones in the first and second embodiments. That is, in this embodiment, the first resonant circuit 110 in the first embodiment is substituted for the resonant circuit 150 in the second embodiment. A second resonant circuit 120 in this embodiment has the same construction as the one in the first embodiment.

In this embodiment, if the impedances Z1(f) and Z2(f) of the resonant circuit part 100 and the oscillating part 200 from an output terminal 101 satisfy the steady oscillating condition of the above equation (2) at a frequency fi in a lowest first frequency-band when a diode D21 is made non-conducting by a resonant frequency-switching voltage to be applied to a third controlling terminal 104 connected to the resonant circuit 100, and a diode D1 is made non-conducting by a resonant frequency selective voltage to be applied to a second controlling terminal 201 connected to an oscillating circuit part 200, the voltage controlled oscillator in this embodiment oscillates stably at the frequency $f_1$.

Moreover, if the impedances Z1(f) and Z2(f) of the resonant circuit part 100 and the oscillating circuit part 200 from the output terminal 101 satisfy the steady oscillating condition of the equation (2) at a frequency $f_2$ in a higher second frequency-band than the first frequency-band when the diode D21 is made conducting by a resonant frequency-switching voltage to be applied to a third controlling terminal 104 connected to the resonant circuit part 100 with maintaining the diode D1 connected to the oscillating circuit part 200 in non-conduction, the voltage controlled oscillator oscillates stably at the frequency $f_2$.

Furthermore, if the impedances Z1(f) and Z2(f) of the resonant circuit part 100 and the oscillating circuit part 200 from the output terminal 101 satisfy the equation (2) at a frequency $f_3$ in a highest frequency-band when the diode D1 is made conducting by an oscillating frequency selective voltage to be applied to a second controlling terminal 201 connected to the oscillating circuit part 200, with maintaining the diode D2 in conduction by the resonant frequency-switching voltage to be applied to the third controlling terminal 104 connected to the resonant circuit 150 in the resonant circuit part 100, the voltage controlled oscillator in this embodiment oscillates stably in its steady state at the frequency $f_3$.

As mentioned in the second embodiment, the frequency-band interval is narrowed by on/off-switching the diode D21 of the resonant circuit 150 in the first resonant circuit part 100, and is broadened by on/off-switching the diode D1 in the oscillating circuit part 200. Therefore, for example, the triple band-type voltage controlled oscillator which can oscillate in the first frequency-band around 800 MHz, in the second frequency-band around 900 MHz and in the third frequency-band around 1.8GHz can be provided. Moreover, by changing the frequency control voltage to be applied to the first controlling terminal 103 in the oscillating circuit part 100 in each of the above three frequency-bands, the oscillating frequency can be finely adjusted and the resonant frequency variation is almost same in each frequency-band.

(Fourth Embodiment)

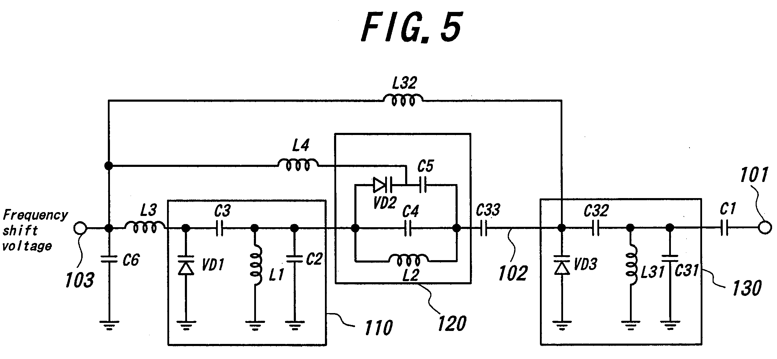

Fig. 5 shows a resonant circuit part 100 in a fourth embodiment of voltage controlled oscillator of the present invention. This embodiment relates to a triple band-type voltage controlled oscillator as in the third embodiment, and the resonant circuit part 100 has a third resonant circuit 130 in addition to the first and second resonant circuits 110 and 120 shown in Fig. 1. The third resonant circuit 130 has a condenser C31 connected in parallel between a line 102 and a ground, a coil L31, a variable capacitance diode VD3 and a condenser C32 connected between the cathode of the variable capacitance diode and the coil L31. Moreover, the second and the third resonant circuits are coupled with a coupling condenser C33.

In the triple band-type voltage controlled oscillator in this embodiment, since the first, the second and the third resonant circuits 110, 120 and 130 in the resonant circuit part 100 are constructed independently, three frequency bands can be independently set. Moreover, since frequency control voltages are applied to variable capacitance diodes VD1, VD2 and VD3 provided in the resonant circuits 110, 120 and 130 from a first controlling terminal 103 via coils L3, L4 and L32, respectively, resonant frequency can be finely adjusted precisely and easily in each frequency-band. (Fifth Embodiment)

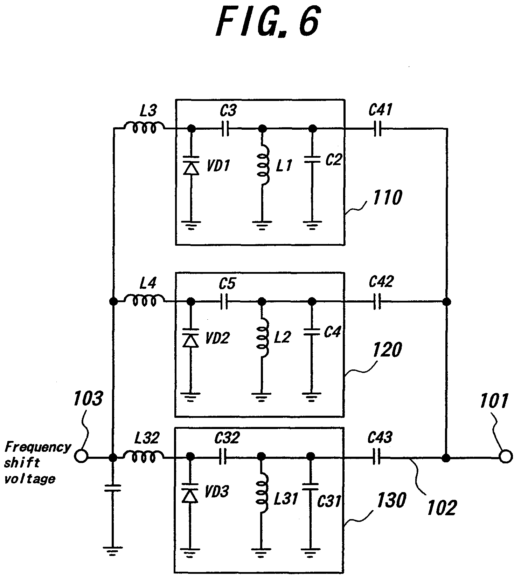

Fig. 6 shows a resonant circuit 100 in a fifth embodiment of voltage controlled oscillator of the present invention. This embodiment also relates to a triple band-type voltage controlled oscillator as in the third and fourth embodiments. The voltage controlled oscillator of this embodiment has the construction that the first, the second and the third resonant circuits 110, 120 and 130 shown in Fig. 5 are connected in parallel to an output terminal 101 by coupling condensers C41, C42 and C43, respectively. In this embodiment as well as the fourth embodiment shown in Fig. 5, since the first, the second and the third resonant circuits 110, 120 and 130 are independently constructed, three frequency-bands can be independently set. Moreover, since frequency control voltages are applied to variable capacitance diodes VD1, VD2 and VD3 provided in the resonant circuits 110, 120 and 130 from a first controlling terminal 103 via coils L3, L4 and L32, respectively, resonant frequency can be finely adjusted precisely and easily in each frequency-band.

In the voltage controlled oscillator having the resonant circuit 100 with three resonant frequencies as shown in the embodiments in Figs. 5 and 6, the frequency band selective circuit of the oscillating circuit part 200 is required to have at least three conditions corresponding to the three resonant frequencies. Next, the oscillating circuit part 200 having such a frequency band selective circuit will be explained.

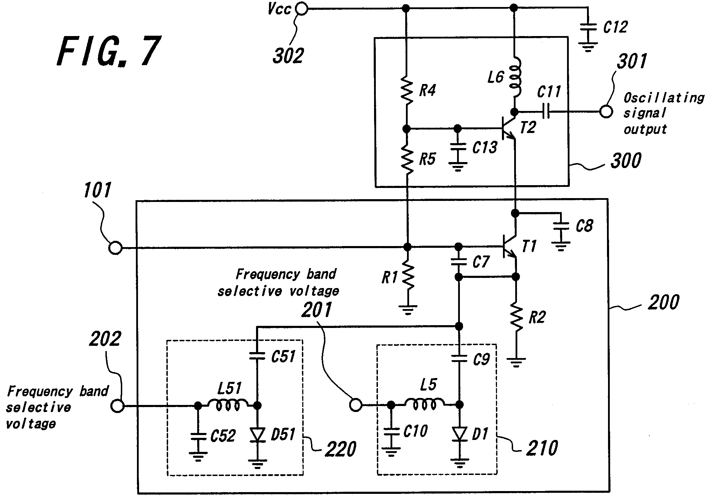

Fig. 7 shows an example of the oscillating circuit parts 200 constructed so as to switch the impedance over the above-mentioned at least three frequency bands. In this embodiment, a second frequency band selective circuit 220 is provided in addition to the frequency band selective circuit 210 provided in the oscillating circuit part 200 in the first embodiment shown in Fig. 1. The second frequency band selective circuit 220 has a series circuit composed of a condenser C51 connected between the emitter of a transistor T1 and a ground, a controlling terminal 202 to which a second frequency band selective voltage is applied from the connected point between the condenser C51 and the diode D51 via a coil L51, and a bypass condenser C52 connected between the controlling terminal 202 and the ground.

In this embodiment, by on/off-switching a diode D1 in the first frequency band selective circuit 210 and a diode D51 in the second frequency band selective circuit 220, the oscillating circuit part 200 can have four conditions shown in Table 1.

Table 1

|  | First condition | Second condition | Third condition | Four condition |
|---|---|---|---|---|
| D1 | OFF | OFF | ON | ON |
| D51 | OFF | ON | OFF | ON |

By determining the circuit constant of the oscillating circuit part 200 so that three conditions from among these four conditions may correspond to the above first, second and three frequency-bands, the above equation (4) can be satisfied in each of the above frequency-bands, and thus, the voltage controlled oscillator can oscillate stably in each of the three frequency-bands.

The invention has been described in detail with reference to the above preferred embodiments, but it is clear for the ordinary person skilled in the art that various modifications can be made in its configuration and detail without departing from the scope of this invention.

Such a voltage controlled oscillator as in the above embodiments is operated at two or three frequency-bands, but may be done at not less than four frequency-bands. Moreover, the above resonant circuits and oscillating circuit parts are simply exemplified and thus, various circuits may be employed.

As mentioned above, the voltage controlled oscillator of the embodiments has a resonant circuit part, and an oscillating circuit part connected to an output terminal of the resonant circuit part. Then, in the resonant circuit part, the plural resonant circuits or the resonant circuit to switch the resonant frequency is provided in the resonant circuit part to generate the plural frequency-bands, and in the oscillating circuit part the oscillating frequency can be selected in accordance with each of the plural frequency-bands. Therefore, the oscillating condition can be almost optimized and thus, a stable oscillating signal can be obtained in each frequency-band.

Moreover, by changing the frequency control voltage in each of the plural frequency-bands, the resonant frequency, that is the oscillating frequency in the voltage controlled oscillator, can be adjusted to the same sensitivity, and thus can be easily set to a precise oscillating frequency over all frequency-bands.

Moreover, in comparison with the conventional case of using two voltage controlled oscillators, the voltage controlled oscillator of the present embodiments can be miniaturized and saved in power. For example, if the voltage controlled oscillator is fabricated as a chip device, it can be miniaturized by 40% or over by volume. Furthermore, since the voltage controlled oscillator has a simpler construction than the conventional dual band-type oscillator with dielectric resonator, it can be miniaturized and manufactured at low cost.

**Claims**

1.  A multi-band type voltage controlled oscillator comprising:

a resonant circuit part having plural resonant frequencies to be controlled in their respective frequency-bands in accordance with a frequency control voltage, and

an oscillating circuit part which is connected to the resonant circuit part and oscillates at an oscillating frequency in a frequency-band selected from the plural frequency-bands in accordance with a frequency band switching voltage.

2. A multi-band type voltage controlled oscillator as defined in claim 1, wherein the resonant circuit part has plural resonant circuits having their resonant frequencies in their respective frequency-bands and coupled to one output terminal.

3. A multi-band type voltage controlled oscillator as defined in claim 2, wherein
the plural resonant circuits have their resonant frequencies to be controlled in their respective frequency-bands in accordance with their respective frequency control voltages.

4. A multi-band type voltage controlled oscillator as defined in claim 1, wherein the resonant circuit part comprises one resonant circuit having plural resonant frequencies which belong to their respective frequency-bands to be switched by a resonant frequency switching voltage and are controlled in their respective frequency-bands in accordance with a frequency control voltage.

5. A multi-band type voltage controlled oscillator as defined in claim 1, wherein the resonant circuit part comprises at least one resonant circuit having a resonant frequency to be controlled in a given frequency-band in accordance with a frequency control voltage, and at least one resonant circuit having plural resonant frequencies which belong to their respective frequency-bands to be switched by a resonant frequency switching voltage and are controlled in accordance with a frequency control voltage.

6. A multi-band type voltage controlled oscillator as defined in any one of claims 1-5, wherein the oscillating circuit part comprises an active element.

7. A multi-band type voltage controlled oscillator as defined in claim 6, further comprising at least one frequency band selective circuit which has, as the active element, a transistor of which the base is connected to an output terminal of the resonant circuit part, constitutes the oscillating circuit part as a Colpitts type oscillator to oscillate at a frequency determined by the capacitance between the base and emitter of the transistor, the inductance between the base and collector of the transistor and the capacitance between the emitter and collector of the transistor, and satisfies an optimum oscillating condition at each of the plural frequency-bands by changing the capacitance between the emitter and collector with a frequency band selective voltage.

8. A multi-band type voltage controlled oscillator as defined in claim 7, wherein the frequency band selective circuit comprises a series circuit composed of a condenser and a diode which are connected to the emitter of the transistor, and a biasing circuit to control the conduction/non-conduction of the diode by applying to it the frequency band selective voltage.

9. A multi-band type voltage controlled oscillator as defined in claim 8, wherein the biasing circuit comprises an inductor connected between a controlling terminal to which the frequency band selective voltage is applied and the anode of the diode, and a condenser connected between the controlling terminal and a common electric potential point.

10. A multi-band type voltage controlled oscillator as defined in any one of claims 1-9, further comprising a frequency control circuit to control each of the plural resonant frequencies in the resonant circuit part in accordance with a common frequency control voltage.

11. A multi-band type voltage controlled oscillator as defined in claim 10, wherein the frequency control circuit comprises a controlling terminal to receive the common frequency control voltage, a variable capacitance diode connected to the respective resonant circuit, and a biasing circuit to change the capacitance of the variable capacitance diode by applying to them the frequency control voltage.

12. A multi-band type voltage controlled oscillator as defined in claim 11, wherein the biasing circuit comprises a coil connected between a controlling terminal to which the frequency control voltage is applied and the anode of the variable capacitance diode, and a condenser connected between the controlling terminal and a common electric

potential point.

# FIG. 1

## FIG. 2A

## FIG. 2B

## FIG. 3

FIG. 4

EP 1 111 771 A2

# FIG. 5

Frequency shift voltage

# FIG. 6

FIG. 7

EP 1 111 771 A2